# EUROPEAN PATENT APPLICATION

(11) **EP 4 262 331 A1**
(43) Date of publication of application: **18.10.2023**
(21) Application number: 21905548.0
(22) Date of filing: 03.12.2021
(51) Int. Cl.: H05K 3/46, H05K 3/00, H05K 1/02

(54) **SINGLE CORE BOARD ALIGNMENT METHOD FOR MULTI-LAYER CIRCUIT BOARD**

(30) Priority: 14.12.2020 CN 202011475890
(71) Applicant: Huawei Technologies Co., Ltd., Shenzhen, Guangdong 518129 (CN)
(72) Inventor: GONG, Lili, Shenzhen, Guangdong 518129 (CN); XIE, Ertang, Shenzhen, Guangdong 518129 (CN); GAO, Feng, Shenzhen, Guangdong 518129 (CN); YE, Jinhua, Shenzhen, Guangdong 518129 (CN)
(74) Representative: Gill Jennings & Every LLP
(86) International application number: PCT/CN2021/135377
(87) International publication number: WO 2022/127619

(57) **Abstract**

This application provides a method for aligning single core boards of a multilayer circuit board. The method includes: first determining a precise region of a specified surface of a single core board, where the precise region of the specified surface of the single core board has a precise region target, and an auxiliary region of the single core board has an auxiliary target; mounting a single core board of a reference board to a board stacking machine; obtaining first coordinates of a precise region target and second coordinates of an auxiliary target of the single core board of the reference board; transporting an N^{th} layer of single core board to the board stacking machine, where N ≥ 2; obtaining third coordinates of a precise region target and fourth coordinates of an auxiliary target of the N^{th} layer of single core board; and stacking the N^{th} layer of single core board and an (N-1)^{th} layer of single core board, so that a deviation between the third coordinates and the first coordinates is not greater than a first specified threshold A, and a deviation between the fourth coordinates and the second coordinates is not greater than a second specified threshold B. Therefore, a layer deviation between single core boards is reduced, an overall layer deviation of a multilayer circuit board is reduced, and outgoing line density of the multilayer circuit board is increased.

## Description

### CROSS-REFERENCE TO RELATED APPLICATIONS

This application claims priority to Chinese Patent Application No. 202011475890.3, filed with the China National Intellectual Property Administration on December 14, 2020 and entitled "METHOD FOR ALIGNING SINGLE CORE BOARDS OF MULTILAYER CIRCUIT BOARD", which is incorporated herein by reference in its entirety.

### TECHNICAL FIELD

This application relates to the field of electronic device technologies, and in particular, to a method for aligning single core boards of a multilayer circuit board.

### BACKGROUND

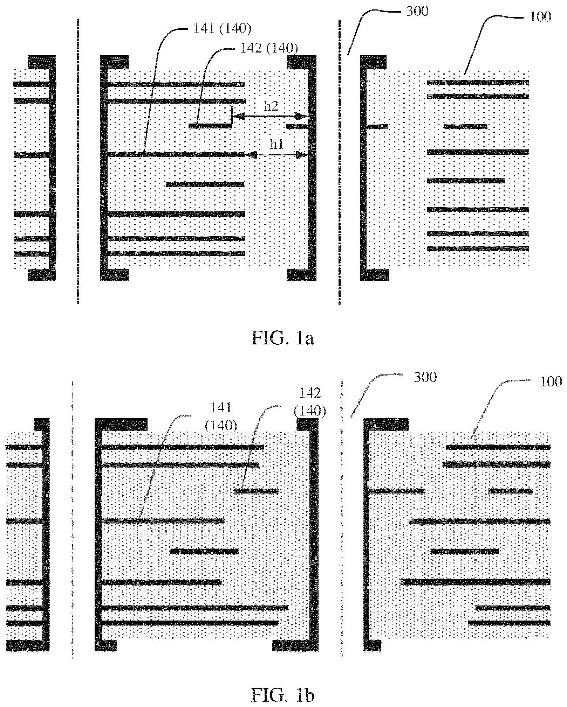

With development of science and technology, electronic devices have more and more functions and tend to be miniaturized. Therefore, neither of a single sided circuit board or a double sided circuit board can meet requirements. Therefore, multilayer circuit boards are increasingly applied to electronic devices, and multilayer lines also need to be disposed inside circuit boards to implement miniaturization of the circuit boards. In a process of manufacturing a multilayer circuit board, single core boards with a circuit pattern may be manufactured first, and then the single core boards are stacked to form the multilayer circuit board. Alignment precision between the single core boards directly affects an overall layer deviation capability of the multilayer circuit board, and affects design of high-density outgoing lines. FIG. 1a is a cross-sectional view of design of a multilayer circuit board, and FIG. 1b is a schematic diagram of impact of a layer deviation of a multilayer circuit board. As shown in FIG. 1b, an actual layer deviation of the multilayer circuit board makes distances from a conductive via to edges of metal layers of different networks deviate from designed values h1 and h2 in FIG. 1a, resulting in a risk of a short circuit. During design, to match a layer deviation capability of the multilayer board, the distances h1 and h2 in the figure need to be designed to be large enough to avoid the risk of a short circuit between different networks. As a result, evolution of multilayer circuit boards to high density and miniaturization is hindered.

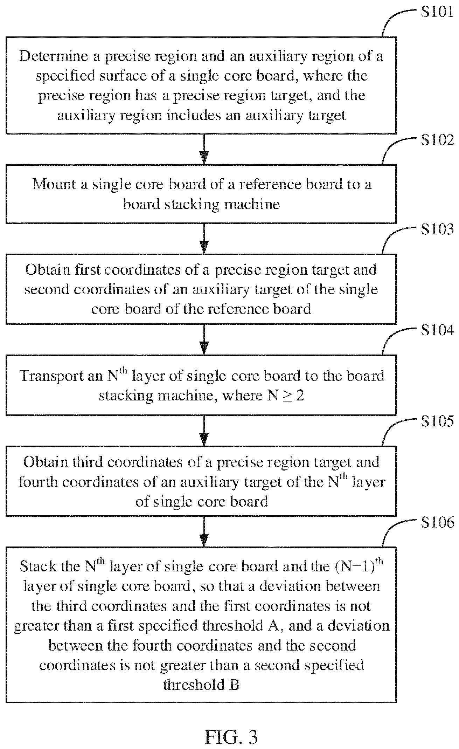

During stacking of single core boards, inter-layer alignment precision is an important factor affecting the overall layer deviation capability of the multilayer circuit board. In the conventional technology, single core boards are aligned in a mechanical alignment manner such as a rivet manner. FIG. 3 is a schematic flowchart of positioning with a rivet in the conventional technology. As shown in the figure, rivet holes are first manufactured in single core boards. Appropriate single core boards are then selected as required. The single core boards are sleeved into a riveting machine in sequence. A plurality of single core boards are riveted by using the riveting machine. The boards are pressed. In this way, stacking of the single core boards of the multilayer circuit board is implemented. In the foregoing process, repetition precision of the rivet holes manufactured in the single core boards, precision of upper and lower molds of the riveting machine, and the like may all affect the alignment precision between the single core boards. As a result, in the conventional technology, a layer deviation of the multilayer circuit board is large, and an outgoing line density of the multilayer circuit board is low.

### SUMMARY

This application provides a method for aligning single core boards of a multilayer circuit board, to reduce a layer deviation between single core boards, reduce an overall layer deviation of the multilayer circuit board, and increase outgoing line density of the multilayer circuit board.

This application provides a method for aligning single core boards of a multilayer circuit board. The method is used to align a plurality of single core boards for manufacturing a multilayer circuit board during manufacturing of the multilayer circuit board. The method specifically includes: first determining a precise region and an auxiliary region of a specified surface of a single core board, where the precise region has a precise region target, and the auxiliary region includes an auxiliary target; mounting a single core board of a reference board to a board stacking machine, where the reference board is a single core board used as an alignment reference during mounting of an N^{th} layer of single core board; obtaining first coordinates of a precise region target and second coordinates of an auxiliary target of the single core board of the reference board, where specifically, the first coordinates and the second coordinates may be obtained by scanning surface topography of the single core board by using a lens and performing image processing and data analysis; then transporting the N^{th} layer of single core board to the board stacking machine, where N ≥ 2; obtaining third coordinates of a precise region target and fourth coordinates of an auxiliary target of the N^{th} layer of single core board, where a manner of obtaining the third coordinates and the fourth coordinates is similar to a manner of obtaining the first coordinates and the second coordinates, or the third coordinates and the fourth coordinates may be obtained by obtaining an image of the surface topography by using the lens and then performing calculation; and stacking the N^{th} layer of single core board and an (N-1)^{th} layer of single core board, so that a deviation between the third coordinates and the first coordinates is not greater than a first specified threshold A, and a deviation between the fourth coordinates and the second coordinates is not greater than a second specified threshold B. In this solution, through the method for aligning single core boards of a multilayer circuit board, a precise region may be used as an alignment reference for alignment, to ensure alignment precision of the precise region, so that overall alignment precision of the multilayer circuit board can be improved. Therefore, this solution can reduce a layer deviation between single core boards, reduce an overall layer deviation of the multilayer circuit board, and increase outgoing line density of the multilayer circuit board.

In a technical solution, the determining a precise region and an auxiliary region of a specified surface of a single core board, where the precise region has a precise region target, and the auxiliary region includes an auxiliary region target specifically includes: manufacturing the precise region target in the precise region of the specified surface of the single core board, and manufacturing the auxiliary target in the auxiliary region of the single core board. In the solution, the precise region target and the auxiliary target are manufactured on the single core board as required to facilitate a subsequent alignment process.

Alternatively, in another technical solution, in addition to that the precise region target and the auxiliary target are manufactured through a subsequent process, the precise region target and the auxiliary target may be formed by using an existing structure on the single core board and defining patterns with specified features as targets. That is, the precise region target may be defined in the precise region of the specified surface of the single core board, and the auxiliary target may be defined in the auxiliary region of the single core board. In this technical solution, a process for manufacturing targets is omitted, and alignment efficiency of single core boards of the multilayer circuit board is high.

The precise region for alignment is the most precise region, and each single core board includes positions of a plurality of conductive vias. A region with a small distance from a conductive via to an edge of a metal layer that is located in a different network from the conductive via is the precise region of the single core board, and a region with the smallest distance from a conductive via to an edge of a metal layer that is located in a different network from the conductive via is the most precise region of the single core board. A specific position of the auxiliary region is not limited, and may be an edge of the single core board, or the auxiliary region may be the second most precise region of the single core board. The second most precise region is a region in which a distance from a conductive via to an edge of a metal layer that is located in a different network from the conductive via is only greater than the distance of the most precise region. When the auxiliary region is the second most precise region, the most precise region and the second most precise region are both used as alignment references, so that alignment precision of the most precise region is improved, and alignment precision of the second most precise region is improved, to improve overall alignment precision of the multilayer circuit board.

The first specified threshold A and the second specified threshold B satisfy: A ≤ B. That is, in the alignment process, the alignment precision of the precise region must be preferentially ensured.

Each single core board includes two surfaces, and the two surfaces are a first surface and a second surface. It is first determined which surface has higher density, and the surface is selected as the specified surface. That is, the surface is used to perform alignment, to improve alignment precision. Specifically, a first minimum distance from a conductive via in a precise region of the first surface to an edge of a metal layer that is located in a different network from the conductive via may be calculated, and a second minimum distance from a conductive via in a precise region of the second surface to an edge of a metal layer that is located in a different network from the conductive via may be calculated. The first surface is determined as the specified surface when the first minimum distance is less than the second minimum distance. The second surface is determined as the specified surface when the first minimum distance is greater than the second minimum distance.

In another technical solution, when the density of the precise region of the first surface is same as the density of the precise region of the second surface, alignment may be performed with reference to the precise regions of two surfaces of the single core board, to improve alignment precision of the multilayer circuit board. Specifically, the first minimum distance from the conductive via in the precise region of the first surface to the edge of the metal layer that is located in a different network from the conductive via is calculated, and the second minimum distance from the conductive via in the precise region of the second surface to the edge of the metal layer that is located in a different network from the conductive via is calculated. The first surface and the second surface are both specified surfaces when the first minimum distance is equal to the second minimum distance. The first coordinates and the third coordinates are fitting center coordinates of a precise region target of the first surface and a precise region target of the second surface of the single core board.

In this solution, the fitting center coordinates may be average values of coordinates of the precise region target of the first surface and coordinates of the precise region target of the second surface. Alternatively, the fitting center coordinates may be coordinates of a center of the precise region target after an image of the first surface is overlapped with an image of the second surface. In summary, the fitting center coordinates are determined by using the precise region target of the first surface and the precise region target of the second surface. In this solution, alignment of precise regions of two surfaces may be taken into consideration, which is beneficial to improving alignment precision.

In the alignment process, during alignment of the N^{th} layer of single core board, the (N-1)^{th} layer of single core board adjacent to the N^{th} layer of single core board may be used as a reference, so that alignment precision of two adjacent layers of single core boards can be ensured. A layer deviation caused by a movement of the first layer of single core board in the alignment process is avoided.

In another technical solution, two adjacent surfaces may be used as relative references for alignment. Specifically, the precise region targets and the auxiliary targets of the first surfaces of and the precise region targets and the auxiliary targets of the second surfaces of the single core boards are separately obtained. During alignment, the first coordinates and the second coordinates on a surface of a side of the (N-1)^{th} layer of single core board facing the N^{th} layer of single core board may be aligned with the third coordinates and the fourth coordinates on a surface of a side of the N^{th} layer of single core board facing the (N-1)^{th} layer of single core board, to further improve the alignment precision.

### BRIEF DESCRIPTION OF DRAWINGS

FIG. 1a is a cross-sectional view of design of a multilayer circuit board;
FIG. 1b is a schematic diagram of impact of a layer deviation of a multilayer circuit board;
FIG. 2 is a schematic diagram of a surface structure of a single core board in the conventional technology;
FIG. 3 is a flowchart of a method for aligning single core boards of a multilayer circuit board according to an embodiment of this application;
FIG. 4 is a schematic diagram of a cross-sectional structure of a multilayer circuit board according to an embodiment of this application;
FIG. 5 is a schematic diagram of a surface structure of a single core board according to an embodiment of this application;
FIG. 6 is a partial enlarged cross-sectional view of a multilayer circuit board according to an embodiment of this application;
FIG. 7a and FIG. 7b are separately partial enlarged views of a pattern of a single core board according to an embodiment of this application;
FIG. 8 is another schematic diagram of cooperation between a lens and a single core board according to an embodiment of this application;
FIG. 9 is a schematic diagram of stacking of single core boards of a multilayer circuit board according to an embodiment of this application;
FIG. 10 is another schematic diagram of a surface structure of a single core board according to an embodiment of this application;
FIG. 11 is a schematic diagram of a cross-sectional structure of a single core board according to an embodiment of this application;
FIG. 12 is another schematic diagram of cooperation between a lens and a single core board according to an embodiment of this application;
FIG. 13 is another schematic diagram of stacking of single core boards of a multilayer circuit board according to an embodiment of this application;
FIG. 14 is another schematic diagram of stacking of single core boards of a multilayer circuit board according to an embodiment of this application;
FIG. 15 is another schematic diagram of stacking of single core boards of a multilayer circuit board according to an embodiment of this application; and
FIG. 16 is a partial enlarged cross-sectional view of a multilayer circuit board according to an embodiment of this application.

### BRIEF DESCRIPTION OF DRAWINGS

| | | | |
|---|---|---|---|
| 100- | single core board; | 110- | board edge target; |
| 120- | board center; | 130- | precise region; |
| 131- | most precise region; | 132- | second most precise region; |
| 140- | metal layer; | 141- | copper sheet; |
| 142- | trace; | 150- | precise region target; |
| 160- | auxiliary target; | 170- | first surface; |
| 180- | second surface; | 200- | semi-cured sheet; |
| 300- | conductive via; and | 400- | Lens. |

### DESCRIPTION OF EMBODIMENTS

Terms used in the following embodiments are merely intended to describe specific embodiments, but are not intended to limit this application. As used in the specification and the appended claims of this application, singular expressions including "one", "one type", "forgoing", "the" and "this" are also intended to include such expressions as "one or more", unless the context clearly indicates to the contrary.

Reference to "an embodiment" or "a specific embodiment" or the like described in this specification means that one or more embodiments of this application include a specific feature, structure, or feature described with reference to the embodiment. The terms "include", "comprise", "have", and variations thereof all mean "including, but not limited to", unless otherwise specified.

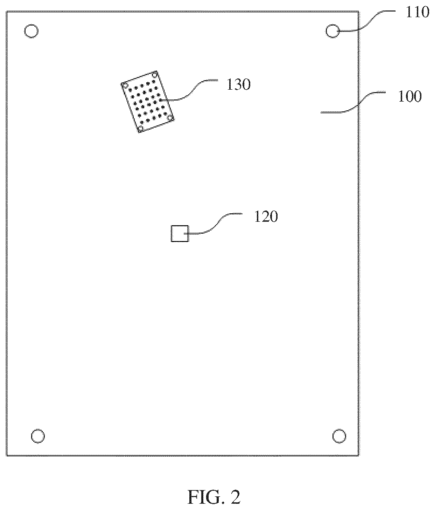

To facilitate understanding of the method for aligning single core boards of a multilayer circuit board provided in embodiments of this application, an application scenario of the method is first described below. With increasing requirements for multilayer circuit boards and higher requirements for outgoing line density of the multilayer circuit boards, higher requirements are raised for a manufacturing process of the multilayer circuit boards, to implement miniaturization of electronic devices. Specifically, during manufacturing of a multilayer circuit board, a single core board needs to be separately manufactured, and then single core boards are stacked to form a multilayer circuit board. During stacking of the single core boards, alignment precision of the single core boards of the multilayer circuit board directly affects outgoing line density of the multilayer circuit board. FIG. 2 is a schematic of a surface structure of a single core board in the conventional technology. As shown in FIG. 2, in the conventional technology, a board edge target 110 of a single core board 100 is used to simulate a board center 120 of the single core board 100 as an alignment center to perform alignment. Theoretically, in the method, the board center 120 of the single core board 100 is a position with optimal alignment precision. However, due to the impact of different expansion and contraction ratios of the single core board 100, a deviation is greater in a region that is farther away from the board center 120. However, a precise region 130 of the single core board 100 may not be located at the board center 120 of the single core board 100. Therefore, alignment precision of the multilayer circuit board needs to be improved. Therefore, this application provides a method for aligning single core boards of a multilayer circuit board. Specific embodiments are provided below to describe the foregoing method.

FIG. 3 is a flowchart of a method for aligning single core boards of a multilayer circuit board according to an embodiment of this application. As shown in FIG. 3, the method for aligning single core boards of a multilayer circuit board includes the following steps.

Step S101: Determine a precise region of a specified surface of a single core board, where the precise region has a precise region target, and an auxiliary region includes an auxiliary target.

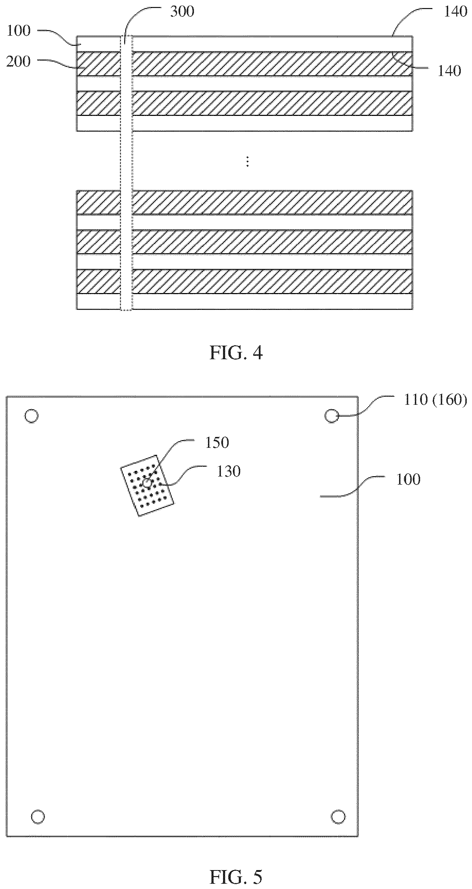

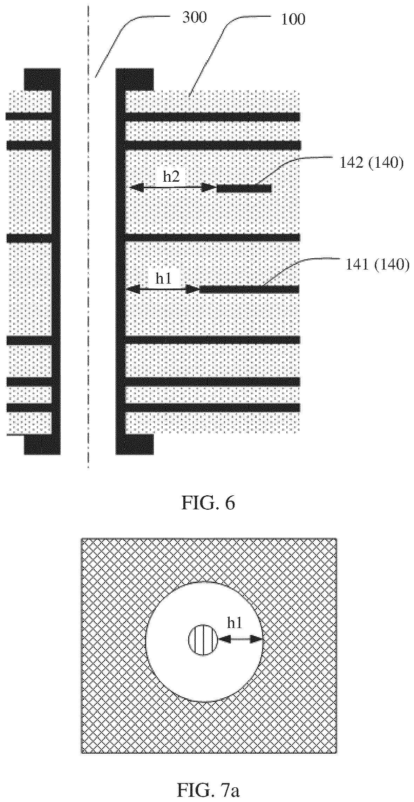

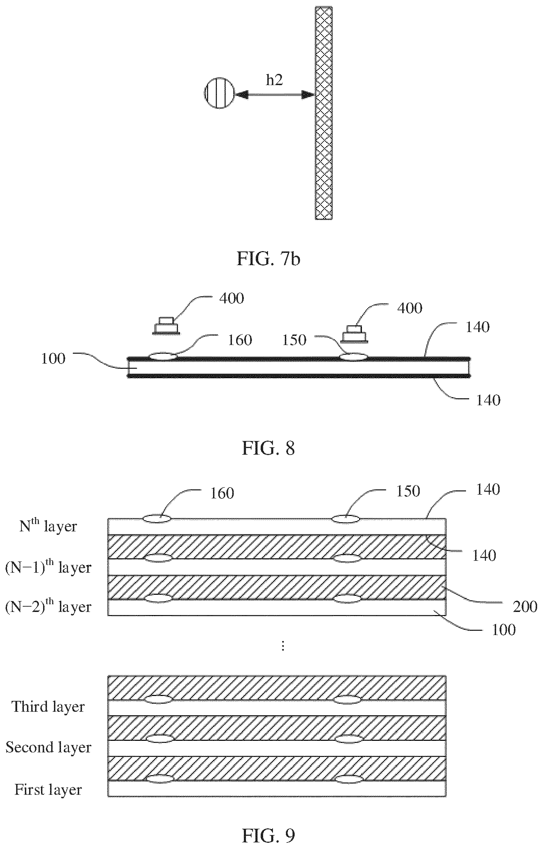

FIG. 4 is a schematic diagram of a cross-sectional structure of a multilayer circuit board according to an embodiment of this application. As shown in FIG. 4, the multilayer circuit board includes a plurality single core boards 100, and a semi-cured sheet 200 is further disposed between adjacent single core boards 100, to implement fixing between the adjacent single core boards 100. To implement a conductive connection between the single core boards 100 of the multilayer circuit board, a conductive via 300 needs to be manufactured on the multilayer circuit board, and the conductive via 300 is electrically connected to a specified line of a metal layer 140 of each single core board 100. Therefore, during design of the single core board 100, a pattern of the metal layer 140 needs to be designed on a surface of the single core board 100, and a position of the conductive via 300 further needs to be designed. Therefore, during stacking of the single core boards 100 is, precise alignment needs to be performed on regions in which the conductive vias 300 of the single core boards 100 are located, so that patterns of traces 142 are designed densely during design of the patterns of the traces 142 of the single core boards 100. FIG. 5 is a schematic diagram of a surface structure of a single core board 100 according to an embodiment of this application. FIG. 6 is a schematic diagram of a cross-sectional structure of a multilayer circuit board according to an embodiment of this application. With reference to FIG. 5 and FIG. 6, a surface of the single core board 100 has a metal layer 140. The metal layer 140 includes a plurality of copper sheets 141 and a plurality of traces 142. The plurality of copper sheets 141 and the plurality of traces 142 of the metal layer 140 may form a plurality of different networks, and each conductive via 300 is located in one of the networks. A distance from the conductive via 300 to a metal layer 140 in a same network may not be limited. However, it needs to be ensured that a distance from the conductive via 300 to a metal layer 140 that is located in a different network from the conductive via 300 is greater than a specified value. FIG. 7a and FIG. 7b are respectively partial enlarged views of a metal layer 140 of a single core board 100 according to an embodiment of this application. With reference to FIG. 6, FIG. 7a, and FIG. 7b, h1 in the figure is a distance from a conductive via 300 to an edge of a copper sheet 141 of a metal layer 140 that is located in a different network from the conductive via 300, and h2 in the figure is a distance from a conductive via 300 to an edge of a trace 142 of a metal layer 140 that is located in a different network from the conductive via 300. Each single core board 100 includes positions of a plurality of conductive vias 300, and a region with a small distance from a conductive via 300 to an edge of a metal layer 140 that is located in a different network from the conductive via 300 is a precise region 130 of the single core board 100, as shown in FIG. 5. It should be noted that the precise regions 130 of the single core boards 100 of a same multilayer circuit board cover each other after being stacked. That is, the precise regions 130 are precise regions 130 of the multilayer circuit board, and are the precise regions 130 relative to a same or a same group of conductive vias 300. Therefore, When the precise regions 130 are used as an alignment standard for the single core boards 100, it can be ensured that an overall layer deviation of the multilayer circuit board is small. In a specific embodiment, the precise region 130 may be the most precise region 131, that is, a region with the smallest distance from a conductive via 300 to an edge of a metal layer 140 that is located in a different network from the conductive via 300, to ensure alignment precision of the region, so that inter-layer alignment precision of the entire multilayer circuit board can be improved.

Step S102: Mount a single core board of a reference board to a board stacking machine.

Step S103: Obtain first coordinates of a precise region target and second coordinates of an auxiliary target of the single core board of the reference board.

FIG. 8 is another schematic diagram of cooperation between a lens and a single core board according to an embodiment of this application, as shown in FIG. 8. The board stacking machine (not shown in the figure) includes a lens 400 and a controller (not shown in the figure) connected to the lens 400. The controller may control the lens 400 to photograph the single core board 100 of the reference board, to obtain surface topography of the single core board 100 of the reference board, identify a precise region target 150 and an auxiliary target 160, and perform calculation to obtain first coordinates of the precise region target 150 and second coordinates of the auxiliary target 160.

Step S104: Transport an N^{th} layer of single core board to the board stacking machine, where N ≥ 2.

Specifically, the single core board may be transported to a workbench region of the board stacking machine by a manipulator, and specifically, the single core board may be transported to a region in which the reference board is located.

Step S 105: obtain third coordinates of a precise region target and fourth coordinates of an auxiliary target of the N^{th} layer of single core board.

Continue to refer to FIG. 8. The controller of the board stacking machine may further control the lens 400 to photograph the N^{th} layer of single core board 100, to obtain surface topography of the N^{th} layer of single core board 100, identify the precise region target 150 and the auxiliary target 160, and perform calculation to obtain third coordinates of the precise region target 150 and fourth coordinates of the auxiliary target 160.

Step S 106: Stack the N^{th} layer of single core board and an (N-1)^{th} layer of single core board, so that a deviation between the third coordinates and the first coordinates is not greater than a first specified threshold A, and a deviation between the fourth coordinates and the second coordinates is not greater than a second specified threshold B.

FIG. 9 is a schematic diagram of stacking of single core boards of a multilayer circuit board according to an embodiment of this application. As shown in the figure, a controller controls a manipulator to move the single core board 100, so that the third coordinates are close to the first coordinates, and a deviation between the third coordinates and the first coordinates is not greater than the first specified threshold A. In addition, the fourth coordinates are close to the second coordinates, and a deviation between the fourth coordinates and the second coordinates is not greater than the second specified threshold B. Therefore, it is considered that alignment of the N^{th} layer of single core board 100 and the reference board is completed. The N^{th} layer of single core board 100 and the (N-1)^{th} layer of single core board 100 are stacked, so that stacking between the N^{th} layer of single core board 100 and the (N-1)^{th} layer of single core board 100 is completed. The process is repeated to complete alignment of the single core boards 100 of the multilayer circuit board, then pressing may be performed, to fix the layers of single core boards 100 to form the multilayer circuit board, and then drilling and other subsequent processes are performed.

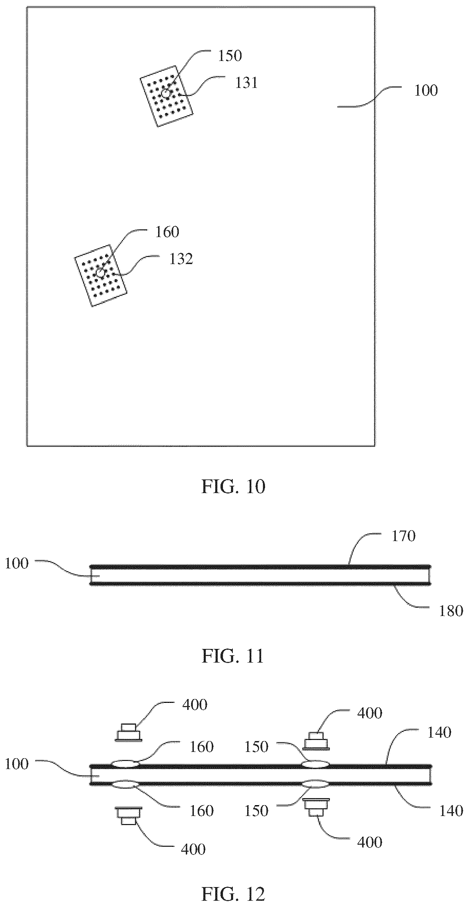

In a specific embodiment, continue to refer to FIG. 5. The precise region 130 of the single core board 100 has the precise region target 150, and the auxiliary region has the auxiliary target 160. Specifically, in step S101, the precise region target 150 is manufactured in the precise region 130 of the specified surface of the single core board 100, and the auxiliary target is manufactured in the auxiliary region. The precise region target 150 and the auxiliary target may be used as alignment references during implementation of inter-layer alignment in a subsequent step. The auxiliary region may be located at an edge or in a second most precise region 132 of the single core board 100. In the embodiment shown in FIG. 5, the auxiliary region is located at the edge of the single core board 100. In addition, FIG. 10 is another schematic diagram of a surface structure of the single core board according to an embodiment of this application. As shown in FIG. 10, the single core board 100 includes the most precise region 131 and the second most precise region 132. The precise region target 150 is located in the most precise region 131, and the auxiliary target 160 is located in the second most precise region 132. The second most precise region 132 is a region in which a distance from a conductive via 300 to an edge of a metal layer 140 that is located in a different network from the conductive via 300 of the single core board 100 is only less than a distance from a conductive via 300 of the most precise region 131 to an edge of a metal layer 140 that is located in a different network from the conductive via 300. Through this solution, alignment precision of the most precise region 131 can be ensured, and alignment precision of the second most precise region 132 can be ensured, so that overall inter-layer alignment precision of the multilayer circuit board is high. When the precise region target 150 cooperates with the auxiliary target 160, the inter-layer alignment precision of the multilayer circuit board can be improved.

For the foregoing precise region target and auxiliary target, additional targets can be manufactured at corresponding positions; or a shape of an appropriate pattern may be selected as a target based on a pattern of a specified surface of the single core board. That is, the precise region target can be defined in the precise region of the specified surface of the single core board, and the auxiliary target can be defined in the auxiliary region of the single core board. In other words, there is no need to manufacture a structure other than the single core board, and the appropriate pattern can be selected as the target by using the structure of the single core board. This solution reduces a process procedure of manufacturing a target and is beneficial to improving process efficiency.

Specifically, when the first specified threshold A and the second specified threshold B are designed, the first specified threshold A and the second specified threshold B may satisfy: A ≤ B. That is, during inter-layer alignment, alignment precision of the precise region 130 needs to be preferentially ensured. When a plurality of single core boards 100 of the multilayer circuit board are stacked, a region with the highest requirement for inter-layer alignment precision is the precise region 130. In the technical solution of this application, a target is manufactured or defined in the precise region 130, and the inter-layer alignment is performed by using the target in the precise region 130. Therefore, the alignment precision of the precise region 130 can be ensured, which is beneficial to improving the inter-layer alignment precision of the entire multilayer circuit board, reduce an overall layer deviation, increase the outgoing line density of the multilayer circuit board, and implement miniaturization of the multilayer circuit board. Specifically, when the foregoing method for aligning single core boards 100 of a multilayer circuit board is used to align the single core boards 100 of the multilayer circuit board, for example, for a high-density BGA (Ball Grid Array, ball grid array) multilayer circuit board, the expansion and contraction of the single core board 100 is 50 µm, the overall layer deviation can be reduced by 13 µm by using the technical solution of this application.

In an actual structure of the single core board 100, patterns of the metal layers 140 on two surfaces of the single core board 100 are different. Therefore, in step S101, a distance from each conductive via 300 on the two surfaces to an edge of a metal layer 140 that is located in a different network from the conductive via 300 may be calculated. A precise region 130 with a smaller distance is selected for alignment, and a surface on which the precise region 130 for alignment is located is used as a specified surface for alignment. FIG. 11 is a schematic diagram of a cross-sectional structure of a single core board 100 according to an embodiment of this application. As shown in FIG. 11, the single core board 100 includes two surfaces, and the two surfaces are a first surface 170 and a second surface 180. With reference to FIG. 6, FIG. 7a, and FIG. 7b, a position of the precise region 130 of the multilayer circuit board is known, and each single core board 100 also has a corresponding precise region 130. A first minimum distance among distances from a conductive via 300 in the precise region 130 of the first surface 170 of each single core board 100 to an edge of a metal layer 140 that is located in a different network from the conductive via 300 is calculated. In other words, each distance from a conductive via 300 in the precise region 130 of the first surface 170 to an edge of a metal layer 140 that is located in a different network from the conductive via 300 is calculated, and all the foregoing distances are compared to select the smallest distance as the first minimum distance. In a same way, the second minimum distance among distances from a conductive via 300 in the precise region 130 of the second surface 180 to an edge of a metal layer 140 that is located in a different network from the conductive via 300 can be calculated. The first minimum distance is compared with the second minimum distance. When the first minimum distance is less than the second minimum distance, the first surface 170 is a specified surface. That is, the precise region target 150 specified in the precise region 130 of the first surface 170 is used as an alignment standard. Certainly, when the first minimum distance is greater than the second minimum distance, the second surface 180 is a specified surface, that is, the precise region target 150 specified in the precise region 130 of the second surface 180 is used as an alignment standard.

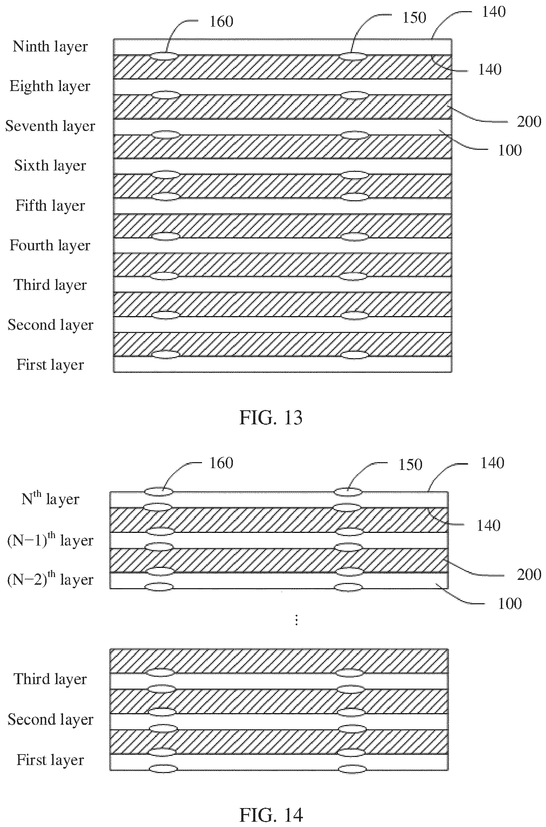

FIG. 12 is another schematic diagram of cooperation between a lens and a single core board according to an embodiment of this application. As shown in FIG. 12, when steps S104 and S106 are performed, a board stacking machine is disposed with a lens 400 on sides of both surfaces of the single core board 100. In this case, coordinates of the corresponding precise region target 150 and auxiliary target 160 may be obtained from a surface of a side in which the specified surface is located, to implement an alignment operation. FIG. 13 is another schematic diagram of stacking of single core boards of a multilayer circuit board according to an embodiment of this application. As shown in FIG. 13, upper surfaces of the first layer of single core board 100 to the fifth layer of single core board 100 are specified surfaces. The precise region targets 150 are manufactured in the precise regions 130 of the upper surfaces as alignment references. Lower surfaces of the sixth layer of single core board 100 to the ninth layer of single core board 100 are specified surfaces. The precise region targets 150 are manufactured in the precise regions 130 of the lower surfaces as alignment references.

In this solution, in consideration of that design of the single core board 100 of each multilayer circuit board is different, actual layout of surfaces of two sides of the single core board 100 may be considered, and a surface of a more precise side is selected as an alignment participation layer for alignment, so that it can be preferentially ensuring that a layer deviation at a more precise position is mitigated, outgoing line density of the multilayer circuit board is higher, and a miniaturization degree of a product is further improved. Specifically, the overall layer deviation of the multilayer circuit board may be reduced by 20 µm to 40 µm, that is, a distance from a conductive via 300 to an edge of a metal layer 140 that is located in a different network from the conductive via 300 may be designed to be shorter by 20 µm to 40 µm, so that density of the multilayer circuit board can be greatly improved.

When step S 101 is performed, that is, when the first minimum distance and the second minimum distance between the precise regions 130 of the two surfaces are calculated, the first minimum distance may be equal to the second minimum distance. In this case, it may be considered that both the first surface 170 and the second surface 180 are specified surfaces. The precise region targets 150 are manufactured on both surfaces when step S102 is performed. When steps S104 and S106 are performed, the board stacking machine is disposed with a lens 400 on sides of both surfaces of the single core board 100. The controller obtains coordinates of the precise region target 150 of the first surface 170 of the single core board 100 and coordinates of the precise region target 150 of the second surface 180 of the single core board 100 by using the lens 400, and calculates the fitting center coordinates of the coordinates of the precise region target 150 of the first surface 170 and the coordinates of the precise region target 150 of the second surface 180. For example, average coordinates of the coordinates of the precise region target 150 of the first surface 170 and the coordinates of the precise region target 150 of the second surface 180 may be selected as the fitting center coordinates. Alternatively, the controller obtains an image of the first surface 170 and an image of the second surface 180 of the single core board 100 by using the lens 400, stacks the two images, and calculate coordinates of a center after the precise region targets 150 of the two surfaces are stacked as the fitting center coordinates. The first coordinates are fitting center coordinates corresponding to the single core board 100, and the third coordinates are also fitting center coordinates corresponding to the single core board 100, and are used to perform an alignment operation. FIG. 14 is another schematic diagram of stacking of single core boards of a multilayer circuit board according to an embodiment of this application. As shown in FIG. 14, two surfaces of each single core board 100 have a precise region target 150 and an auxiliary target 160, and alignment is performed by using fitting center coordinates.

In a technical solution, a reference board may be an (N-1)^{th} layer of single core board 100. That is, during alignment of an N^{th} layer of single core board 100, first coordinates and second coordinates of the (N-1)^{th} layer of single core board 100 that have been aligned and stacked need to be obtained first. Next, the third coordinates and the fourth coordinates of the N^{th} layer of single core board 100 are aligned with the first coordinates and the second coordinates of the (N-1)^{th} layer of single core board 100, to implement alignment of the single core boards 100 of the multilayer circuit board. This solution can ensure precise alignment of the precise regions 130 of adjacent layers, and can prevent a large deviation of a subsequently aligned single core board 100 when the first layer of single core board 100 has a displacement on the board stacking machine. This solution can better avoid a layer deviation caused by a problem such as a displacement of the first layer of single core board 100 each time.

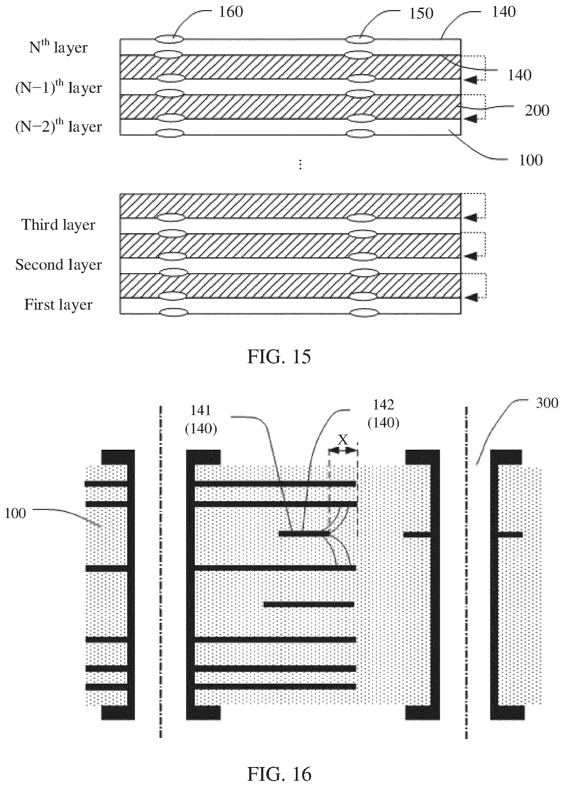

FIG. 15 is another schematic diagram of stacking of single core boards of a multilayer circuit board according to an embodiment of this application. As shown in FIG. 15, in still another technical solution, alignment is performed on surfaces of opposite sides of adjacent layers. That is, the third coordinates and the fourth coordinates on a surface of a side of the N^{th} layer of single core board 100 facing the (N-1)^{th} layer of single core board are aligned with the first coordinates and the second coordinates on a surface of a side of the (N-1)^{th} layer of single core board facing the N^{th} layer of single core board, so that alignment precision of the opposite surfaces can be ensured. This solution is based on a solution in which the precise region target 150 and the auxiliary target 160 are manufactured on two sides of the single core board 100. This process is not described in detail in this application.

FIG. 16 is a partial enlarged cross-sectional view of a multilayer circuit board according to an embodiment of this application. As shown in FIG. 16, a metal layer 140 of a single core board includes a trace 142 and a copper sheet 141. Two layers of copper sheets 141 may block a signal in the trace 142 between the two copper sheets 141, to reduce crosstalk in the traces 142 of different layers of single core boards. In addition, the copper sheet 141 needs to extend a specified distance X relative to an edge of the trace 142, to prevent a signal in the trace 142 from being transferred to the conductive via 300. Considering a layer deviation that may exist during alignment of the single core boards 100 of the multilayer circuit board, it is usually necessary to design an extension design distance Y of the copper sheet 141 relative to the edge of the trace 142, and Y ≥ X. Specifically, a difference between the design distance Y and the specified distance X is Δ = Y - X, and Y = X + Δ. A value of Δ depends to a large extent on a layer deviation capability of the multilayer circuit board. In the technical solution of this application, the layer deviation capability is strong. Therefore, the value of Δ may be small, and the design distance Y may be small, which is beneficial to increasing density of the multilayer circuit board.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A method for aligning single core boards of a multilayer circuit board, comprising:
determining a precise region and an auxiliary region of a specified surface of a single core board, wherein the precise region has a precise region target, and the auxiliary region has an auxiliary target;
mounting the single core board of a reference board to a board stacking machine;
obtaining first coordinates of a precise region target and second coordinates of an auxiliary target of the single core board of the reference board;
transporting an N^{th} layer of single core board to the board stacking machine, wherein N ≥ 2;
obtaining third coordinates of a precise region target and fourth coordinates of an auxiliary target of the N^{th} layer of single core board; and
stacking the N^{th} layer of single core board and an (N-1)^{th} layer of single core board, so that a deviation between the third coordinates and the first coordinates is not greater than a first specified threshold A, and a deviation between the fourth coordinates and the second coordinates is not greater than a second specified threshold B.

2. The alignment method according to claim 1, wherein the precise region is the most precise region, and the auxiliary region comprises an edge or the second most precise region of the single core board.

3. The alignment method according to claim 2, wherein the first specified threshold A and the second specified threshold B satisfy: A ≤ B.

4. The alignment method according to any one of claims 1 to 3, wherein two surfaces of the single core board are a first surface and a second surface, a first minimum distance from a conductive via in a precise region of the first surface to an edge of a metal layer that is located in a different network from the conductive via is calculated, and a second minimum distance from a conductive via in a precise region of the second surface to an edge of a metal layer that is located in a different network from the conductive via is calculated;
the first surface is determined as the specified surface when the first minimum distance is less than the second minimum distance; and
the second surface is determined as the specified surface when the first minimum distance is greater than the second minimum distance.

5. The alignment method according to any one of claims 1 to 3, wherein two surfaces of the single core board are a first surface and a second surface, a first minimum distance from a conductive via in a precise region of the first surface to an edge of a metal layer that is located in a different network from the conductive via is calculated, and a second minimum distance from a conductive via in a precise region of the second surface to an edge of a metal layer that is located in a different network from the conductive via is calculated;
the first surface and the second surface are both specified surfaces when the first minimum distance is equal to the second minimum distance; and
the first coordinates and the third coordinates are fitting center coordinates of a precise region target of the first surface and a precise region target of the second surface of the single core board.

6. The alignment method according to any one of claims 1 to 5, wherein for the N^{th} layer of single core board, the single core board of the reference board is the (N-1)^{th} layer of single core board.

7. The alignment method according to claim 6, wherein the first coordinates and the second coordinates are located on a surface of a side of the (N-1)^{th} layer of single core board facing the N^{th} layer of single core board; and the third coordinates and the fourth coordinates are located on a surface of a side of the N^{th} layer of single core board facing the (N-1)^{th} layer of single core board.

8. The alignment method according to any one of claims 1 to 7, wherein the determining a precise region and an auxiliary region of a specified surface of a single core board, wherein the precise region of the specified surface of the single core board has a precise region target, and the auxiliary region of the single core board has an auxiliary region target specifically comprises:
manufacturing the precise region target in the precise region of the specified surface of the single core board, and manufacturing the auxiliary target in the auxiliary region of the single core board.

9. The alignment method according to any one of claims 1 to 7, wherein thedetermining a precise region and an auxiliary region of a specified surface of a single core board, wherein the precise region of the specified surface of the single core board has a precise region target, and the auxiliary region of the single core board has an auxiliary region target specifically comprises:
defining the precise region target in the precise region of the specified surface of the single core board, and defining the auxiliary target in the auxiliary region of the single core board.
